# EUROPÄISCHE PATENTANMELDUNG

(11) **EP 4 506 317 A1**
(43) Veröffentlichungstag der Anmeldung: **12.02.2025**
(21) Anmeldenummer: 23190227.1
(22) Anmeldetag: 08.08.2023
(51) Int. Cl.: C03B 37/014

(54) **ROHRFÖRMIGER VERBUNDKÖRPER AUS QUARZGLAS SOWIE VERFAHREN ZUR HERSTELLUNG UND VERWENDUNG DESSELBEN**

(71) Anmelder: Heraeus Quarzglas GmbH & Co. KG, 63450 Hanau (DE)
(72) Erfinder: Lehmann, Walter, 63801 Kleinostheim (DE); Badeke, Klaus-Uwe, 06803 Bitterfeld (DE); Hengstermann, Martin, 06803 Bitterfeld (DE); Zwarg, Steffen, 06803 Bitterfeld (DE); Hünermann, Michael, 63801 Kleinostheim (DE)
(74) Vertreter: Heraeus IP

(57) **Zusammenfassung**

Ein bekanntes Verfahren zur Herstellung eines rohrförmigen Quarzglas-Verbundkörpers in einem Außenabscheideverfahren umfasst die Verfahrensschritte: Bereitstellen eines Substratrohres, Rotieren des Substratrohres um eine Rotationsachse, Abscheiden von SiO₂-Partikeln auf der Außenmantelfläche des Substratrohres unter Bildung eines Verbunds aus dem Substratrohr und einem SiO₂-Sootkörper, und Sintern des Verbunds durch Erhitzen bei einer Sintertemperatur unter Bildung des rohrförmigen Quarzglas-Verbundkörpers. Um hiervon ausgehend die reproduzierbare Herstellung eines rohrförmigen Verbundkörpers aus Quarzglas mit besonders großem Innendurchmesser von mehr als 200mm und mit einer Wandstärke von mehr als 25mm zu ermöglichen, wird vorgeschlagen, dass ein Substratrohr bereitgestellt wird, das mindestens teilweise aus Quarzglas einer ersten Quarzglasqualität besteht, und dass der Sootkörper aus Quarzglas einer zweiten Quarzglasqualität besteht, wobei die erste Quarzglasqualität bei der Sintertemperatur eine materialspezifische Viskosität aufweist, die höher ist als die materialspezifische Viskosität der zweiten Quarzglasqualität.

## Beschreibung

### Technischer Hintergrund

Die vorliegende Erfindung betrifft einen Verbundkörper aus Quarzglas, insbesondere einen rohrförmigen Verbundkörper aus Quarzglas mit einer Länge von mindestens 1000mm, einer Rohwandung und einem Innendurchmesser von mindestens 250mm.

Außerdem betrifft die Erfindung die Herstellung eines rohrförmigen Quarzglas-Verbundkörpers, insbesondere ein Verfahren zur Herstellung eines rohrförmigen Quarzglas-Verbundkörpers in einem Außenabscheideverfahren umfassend die folgenden Verfahrensschritte:
(a) Bereitstellen eines Substratrohres, das eine durchgehende und koaxial zu einer Substratrohr-Längsachse verlaufende Durchgangsöffnung, einen Substratrohr-Außendurchmesser, einen Substratrohr-Innendurchmesser, eine Substratrohr-Wandstärke, eine Substratrohr-Außenmantelfläche und eine Substratrohr-Innenmantelfläche aufweist,
(b) Rotieren des Substratrohres um eine koaxial oder parallel zur Substratrohr-Längsachse verlaufende Rotationsachse,
(c) Abscheiden von SiO₂-Partikeln auf der Außenmantelfläche des Substratrohres mittels mindestens eines Abscheidebrenners unter Bildung eines Verbunds aus dem Substratrohr und einem SiO₂-Sootkörper,
(d) Sintern des Verbunds durch Erhitzen bei einer Sintertemperatur unter Bildung des rohrförmigen Quarzglas-Verbundkörpers.

Bauteile aus Quarzglas in Form von Vorformen, Rohren, Stäben, Flanschen, Platten, Ringen, Reaktoren, Tiegel und dergleichen werden in der Halbleiterfertigung und zur Herstellung optischer Fasern eingesetzt. Derartige Bauteile werden häufig aus rohrförmigem Halbzeug aus Quarzglas erzeugt, indem diese thermisch umgeformt und/oder mechanisch bearbeitet werden. Im Zuge von Produktivitätssteigerungen werden zunehmend größere Abmessungen derartiger Bauteile angestrebt, was insbesondere bei rohrförmigem Halbzeug mit größeren Wandstärken und Innendurchmessern verbunden ist.

Für die Herstellung von rohrförmigem Halbzeug aus synthetisch erzeugtem Siliziumdioxid sind CVD-Verfahren (Chemical Vapor Deposition) bekannt, bei denen SiO₂-Partikel aus der Gasphase auf einem Substrat abgeschieden werden. Das unter der Kurzform "OVD" (Outside Vapor Deposition) bekannte CVD-Außenabscheideverfahren ist für die Herstellung von großvolumigem Halbzeug grundsätzlich geeignet. Dabei wird ein siliziumhaltiges Ausgangsmaterial in einer Reaktionszone mittels Flammhydrolyse oder Pyrolyse zu SiO₂-Partikeln umgesetzt und diese schichtweise auf dem Außenmantel eines um seine Längsachse rotierenden zylinderförmigen Substrats abgeschieden. Die Reaktionszone wird mittels einer Heizquelle erzeugt, wobei sich die Substrat-Längsachse und die Heizquelle relativ zueinander reversierend hin- und herbewegen. Das Substrat kann rohrförmig ausgeführt sein und wird hier und im Folgenden auch als "Substratrohr" bezeichnet. Das Substratrohr besteht beispielsweise aus Quarzglas, SiC, SiSiC (reaktionsgebundenem siliziuminfiltrierten Siliciumcarbid), Al₂O₃ oder einem anderen keramischen Werkstoff oder aus Grafit und wird mittels einer drehbankähnlichen Vorrichtung, die hier auch als "Substratrohr-Halterung" bezeichnet wird, gehalten und um seine Längsachse rotiert.

Je nach Temperatur beim Abscheideverfahren ist die auf dem Substratrohr abgeschiedene Schicht aus synthetischem SiO₂ noch porös und wird im Folgenden auch als "Sootschicht" oder als "Sootkörper" bezeichnet, oder sie bildet eine dichte Schicht aus mehr oder weniger transparentem Quarzglas. Im Fall eines porösen Sootschicht wird diese in einem separaten Verfahrensschritt zu mehr oder weniger transparentem Quarzglas gesintert (der Sinterprozess wird auch als "Verglasen" bezeichnet). Aus dem so erzeugten rohrförmigen Quarzglas-Halbzeug wird durch mechanische, chemische und/oder thermische Nachbearbeitung ein Bauteil aus synthetischem Quarzglas erhalten, wie zum Beispiel ein Vollzylinder, ein Hohlzylinder oder Teile dieser Komponenten, die selbst auch als Halbzeug für die Herstellung anderer Bauteile dienen können.

### Stand der Technik

Die US 8,316,671B2 beschreibt ein OVD-Außenabscheideverfahren zur Herstellung eines Hohlzylinders aus Quarzglas. Dabei wird ein Substratrohr aus Quarzglas bereitgestellt, und auf dessen Außenmantelfläche wird eine poröse SiO₂-Sootschicht abgeschieden. Der Verbund aus Substratrohr und SiO₂-Sootschicht wird so verglast, dass die Innenseite des Substratrohres unterhalb der Verformungstemperatur bleibt. Dazu kann die Innenbohrung des Substratrohres beim Verglasungsprozess durch ein Gas oder eine Flüssigkeit gekühlt werden. Die Innenwandung des so erzeugten, rohrförmigen Verbundkörpers aus Quarzglas wird von dem Substratrohr gebildet; sie ist glatt und muss nicht mehr mechanisch bearbeitet werden.

Aus der US 2013/115391 A1 ist ein Verfahren zur Herstellung von Quarzglas-Hohlzylindern mit großem Außendurchmesser bekannt, wobei mittels OVD-Außenabscheideverfahren ein poröser Sootkörper aus Siliziumdioxid-Ruß auf einem Substrat abgeschieden wird. Nach dem Entfernen des Substrats wird der Sootkörper unter Bildung eines Hohlzylinders gesintert. Daraus werden Ringe gesägt, die aus Quarzglas mit einem niedrigen Chlorgehalt und gleichzeitig einem niedrigen Hydroxylgruppengehalt bestehen und deshalb eine hohe Viskosität aufweisen. Die Quarzglasringe werden als sogenannte "Plasmaätzringe" zur Halterung von HalbleiterWafern in Plasmaätzanlagen eingesetzt.

Zum Verglasen des Sootkörpers wird dieser in einem Sinterofen in vertikaler Ausrichtung oder in horizontaler Ausrichtung seiner Längsachse gehalten. Bei vertikaler Ausrichtung der Längsachse kann der Sootkörper auf einem Podest stehend verglast werden. Dabei besteht allerdings die Gefahr, dass sich der Sootkörper aufgrund seines Gewichts verformt und in sich zusammensackt. Dabei kann sich eine raupenartige Struktur aus umlaufenden Falten ausbilden, so dass die Maßhaltigkeits-Anforderungen nicht erfüllt werden können, insbesondere kann es zu einer Überschreitung des vorgegebenen minimalen Innendurchmessers kommen.

Einen Teil dieser Nachteile vermeidet das aus der EP 701 975 A2 bekannte Verfahren. Dabei wird der rohrförmige Sootkörper in einen Verglasungsofen eingebracht und darin in vertikaler Orientierung mittels einer Haltevorrichtung gehalten, die einen Haltestab umfasst, der sich von oben durch die Innenbohrung des Sootkörpers erstreckt und der mit einem Haltefuß verbunden ist, auf dem der Sootkörper anfangs mit seinem unteren Ende aufsteht. Der Haltestab besteht aus kohlefaserverstärktem Grafit (CFC; carbon fiber reinforced carbon) und er ist eng von einem gasdurchlässigen, dünnwandigen Hüllrohr aus reinem Grafit umhüllt. In einer Position oberhalb des oberen Endes des Hüllrohres ist in die Innenbohrung des Sootkörpers ein Grafittragring eingebettet, der aus der Sootkörper-Wandung nach innen in die Sootkörper-Innenbohrung hineinragt.

Beim Verglasen wird der Sootkörper zonenweise, mit seinem oberen Ende beginnend durch ein ringförmiges Heizelement bewegt. Dabei kollabiert der Sootkörper sukzessive auf das Grafit-Hüllrohr auf und schrumpft auch in seiner Länge, wobei es in einer ersten Sinterphase auf dem Haltefuß aufsteht. Die Position des im Sootkörper eingebetteten Grafittragrings ist so gewählt, dass sich dieser in einer zweiten Sinterphase infolge der zunehmenden Längenschrumpfung auf dem Grafit-Hüllrohr abstützt, so dass dann der Sootkörper am oberen Ende hängend gehalten wird. Diese Methode wird im Folgenden auch als "hängende Verglasung" bezeichnet. Nach dem Verglasen wird das Hüllrohr entfernt, und die Innenbohrung des erhaltenen Quarzglasrohres wird durch Bohren, Schleifen, Honen oder Ätzen nachbearbeitet.

Zur Verminderung der Grafitkontaktflächen ist bei einer Abwandlung dieses Verfahrens gemäß der DE 103 03 290 B3 zwischen dem Haltestab und dem zu verglasenden Sootkörper eine Hülse aus synthetischem Quarzglas vorgesehen. Die Herstellung dieser Hülse ist mit hohem Zeit- und Kostenaufwand verbunden und sie ist oder wird Bestandteil des Quarzglasrohres.

Bei dem aus der DE 100 64 730 A bekannten Verfahren werden SiO₂-Partikel auf einem länglichen, um seine Längsachse rotierenden Substratrohr abgeschieden, das über seine Länge eine Abstufung seines Außendurchmessers aufweist. Nach Entnahme des abgestuften Substratrohres wird ein poröser, hohlzylindrischer Sootkörper erhalten, dessen Innenbohrung eine dem Substratrohr-Außendurchmesserprofil entsprechende Komplementärform aufweist, das heißt, sie hat einen stufenförmigen Absatz. Der so erhaltene Sootkörper wird in vertikaler Ausrichtung in einem Ofen hängend verglast, wobei der verengte Bereich der Innenbohrung oben angeordnet ist und ein von oben in die Innenbohrung hineinragender Haltestab den stufenförmigen Absatz untergreift. Die verlässliche Halterung eines schweren Sootkörpers erfordert einen relativ breiten Absatz der Innenbohrung.

### Technische Aufgabe

Mit zunehmend größeren Quarzglaszylindern erschweren das Gewicht der zu sinternden Sootkörper sowie die zunehmenden Temperaturunterschiede zwischen innen und außen das Herstellungsverfahren. Mit den oben beschriebenen Verfahrensweisen sind eine verlässliche Halterung schwerer Sootkörper beim Verglasen und eine reproduzierbare Herstellung von Rohren aus Quarzglas problematisch. Insbesondere ist Ausschuss in einem späten Verfahrensstadium, wie beispielsweise beim Verglasen des Sootkörpers, zu vermeiden.

Ähnliche Problemstellungen ergeben sich auch beim Verglasen anderer Körper aus porösem SiO₂, die nicht über die SiO₂-Sootroute erzeugt worden sind, etwa bei porösen SiO₂-Körpern, die über die bekannte Sol-Gel-Route oder durch Pressverfahren erhalten worden sind.

Der Erfindung liegt daher die Aufgabe zugrunde, ein Verfahren zur Herstellung derartiger großvolumiger, rohrförmiger Verbundkörper aus Quarzglas anhand eines Außenabscheideverfahrens anzugeben; insbesondere anhand eines OVD-Außenabscheideverfahrens.

Insbesondere liegt der Erfindung die Aufgabe zugrunde, ein Verfahren zur reproduzierbaren Herstellung eines rohrförmigen Verbundkörpers aus Quarzglas mit einem großen Innendurchmesser nach dem Außenabscheideverfahren anzugeben, insbesondere mit einem Innendurchmesser von mehr als 200mm und mit einer Wandstärke von mehr als 25mm, das die oben genannten Nachteile vermeidet, und bei dem insbesondere die Gefahr von Ausschuss vermindert ist.

Außerdem liegt der Erfindung die Aufgabe zugrunde, einen rohrförmigen Quarzglas-Verbundkörper bereitzustellen, der sich einerseits durch große Abmessungen, insbesondere durch einen Innendurchmesser von mehr als 200mm, einer Wandstärke von mehr als 25mm und eine Länge von mindestens 1000mm, und gleichzeitig durch hohe Maßhaltigkeit auszeichnet.

### Allgemeine Beschreibung der Erfindung

Hinsichtlich des Verfahrens zur Herstellung des rohrförmigen Verbundkörpers aus Quarzglas wird diese Aufgabe ausgehend von einem Verfahren der eingangs genannten Gattung erfindungsgemäß dadurch gelöst, dass ein Substratrohr bereitgestellt wird, das mindestens teilweise aus Quarzglas einer ersten Quarzglasqualität besteht, und dass der Sootkörper aus Quarzglas einer zweiten Quarzglasqualität besteht, wobei die erste Quarzglasqualität bei der Sintertemperatur eine materialspezifische Viskosität aufweist, die höher ist als die materialspezifische Viskosität der zweiten Quarzglasqualität.

Das Verfahren umfasst einen Verfahrensschritt, bei dem anhand eines Außenabscheideverfahrens, insbesondere anhand eins OVD-Außenabscheideverfahrens, ein SiO₂-poröser Sootkörper aus synthetischem Siliziumdioxid erzeugt wird, der im Folgenden auch kurz als "Sootkörper" bezeichnet wird. Der poröse SiO₂-Sootkörper kann optional einer Dehydratationsbehandlung in Inertgas, chlorhaltigem Gas oder unter Vakuum unterzogen werden, um den Hydroxylgruppengehalt des Quarzglases zu verringern, bevor er zu dem einem mehr oder weniger transparenten Quarzglas gesintert wird. Das Sintern (oder Verglasen) erfolgt beispielsweise unter Vakuum oder in einer Helium und/oder Wasserstoff und/oder Stickstoff enthaltenden Atmosphäre.

Das Substratrohr ist dazu ausgelegt, auf seiner Außenmantelfläche den SiO₂-Sootkörper mit großem Innendurchmesser anhand des Außenabscheideverfahrens zu erzeugen. Das Substratrohr hat beispielsweise eine Substratrohr-Länge bis zu 4m und ist über die gesamte Länge oder über eine Teillänge zylinderförmig, konisch oder stufig ausgeführt. Die Innenkontur ist über die Substratrohr-Länge konstant oder sie verändert sich.

Das Substratrohr verbleibt nach Abschluss des Abscheideverfahrens im Verbund aus Substratrohr und Sootkörper und wird Bestandteil des zu erzeugenden, rohrförmigen Quarzglas-Verbundkörpers (im Folgenden auch kurz als "Quarzglas-Verbundkörper" oder "Verbundkörper" bezeichnet). Es besteht aus Quarzglas und hat vorzugsweise einen Innendurchmesser von mindestens 250mm. Seine Wandstärke liegt bevorzugt im Bereich von 4mm bis 10mm und ist somit klein bezogen auf seinen Außendurchmesser.

Die Wandstärke beträgt in der Regel weniger als 20% des Substratrohr-Außendurchmessers. Dadurch hat das Substratrohr einerseits ein geringes Gewicht, was die Dynamik der Rotationsbewegung verringert und die Handhabung und Ausrichtung erleichtert, und andererseits hat es eine geringe thermische Masse, was die Wärmeableitung und die Ausbildung thermischer Spannungen innerhalb der Wandung geringhält.

Andererseits ist die Wandstärke des Substratrohres groß genug, um einen großvolumigen SiO₂-Sootkörper tragen zu können. Daher beträgt die Wandstärke des Substratrohres bevorzugt mindestens 1% des Substratrohr-Außendurchmessers. Die Wandstärke "W_{S}" (in mm) kann auch von der Substratrohr-Länge abhängen. Es ist vorteilhaft, wenn mit zunehmender Länge des Substratrohres auch die Wandstärke zunimmt. Daher kann Ws alternativ in Abhängigkeit vom Substratrohr-Außendurchmesser Ds (in mm) unter zusätzlicher Berücksichtigung der Substratrohr-Länge "L_{S}" (in mm) auch wie folgt eingestellt werden: W_{S}<0,2*(L_{S}/2000mm)*D_{S}.

Nach Abschluss des Außenabscheideverfahrens und der optionalen Dehydratationsbehandlung des Sootkörpers erfolgt das Sintern (Verglasen) des Sootkörpers gemäß Verfahrensschritt (d), und zwar in Form eines Verbundes aus Substratrohr und SiO₂-Sootkörper, also in Verbindung mit dem Substratrohr. Das dafür eingesetzte Substratrohr zeichnet sich durch eine hohe thermische Stabilität aus, so dass es beim Sintern des Sootkörpers weniger weich wird als der Sootkörper. Das thermisch stabilere Substratrohr verleiht dem erweichenden Sootkörper einen gewissen Halt, so dass dieser die gewünschte zylinderförmige Form erreicht beziehungsweise beibehält.

Dazu trägt bei, dass sowohl das Substratrohr als auch der Sootkörper aus SiO₂ bestehen und sich demnach in ihren thermischen Ausdehnungskoeffizienten nicht oder nicht nennenswert unterscheiden. Der Sootkörper sintert am Substratrohr an, so dass eine gewisse Haftung im Verbund gewährleistet und verhindert wird, dass sich der Sootkörper beim Sintern vom Substratrohr ablöst.

Die vergleichsweise höhere Viskosität des Substratrohres wird beispielsweise dadurch erreicht, dass es über mindestens einen Teil seiner Länge und/oder mindestens über einen Dickenbereich seiner Wandung aus einem Quarzglas besteht, das bei der Sintertemperatur eine höhere Viskosität aufweist als das synthetische Quarzglas des Sootkörpers. Im einfachsten und bevorzugten Fall besteht das Substratrohr vollständig aus dem Quarzglas der ersten Quarzglasqualität, also dem höherviskosen Quarzglas. Bei einer anderen, gleichermaßen bevorzugten Ausführungsform besteht das Quarzglas des Substratrohres nur über einen Teil seiner Länge aus einem höherviskosen Quarzglas, beispielsweise in dem Teil seiner Länge, die beim Sintern des Sootkörpers als Halterung im Sinterofen genutzt wird.

Die Sintertemperatur liegt typischerweise im Bereich von 1200°C bis 1450°C. Es hat sich bewährt, wenn bei einer Messtemperatur von 1350°C der dekadische Logarithmus der Viskosität der ersten Quarzglasqualität um mindestens 0,25 Ig(dPa*s), vorzugsweise um mindestens 0,4 lg(dPa·s) besonders bevorzugt um mindestens 0,6 lg(dPa·s) höher ist als der des Quarzglases der zweiten Quarzglasqualität. Die Viskositätsunterschiede werden hier als Differenz des dekadischen Logarithmus Ig(dPa·s) der jeweiligen Viskositätswerte angegeben. Größere Viskositätsunterschiede als 1 lg(dPa·s) bei der Messtemperatur sind in der Regel nicht erforderlich.

Die Viskosität von Quarzglas kann durch Versteifung von dessen Glas-Netzwerkstruktur und insbesondere durch Dotierstoffe verändert werden. Eine Versteifung der Glas-Netzwerkstruktur kann durch Sauerstoffdefektzentren (auch bekannt als "ODC-Zentren" - Oxygen Deficiency Centers) erreicht werden. Stickstoff, Titanoxid und Aluminiumoxid sind Dotierstoffe, die geeignet sind, die Viskosität von Quarzglas zu erhöhen. Im Hinblick darauf ist bei einer bevorzugten Verfahrensweise vorgesehen, dass das Quarzglas der ersten Quarzglasqualität einen Gehalt an Aluminiumoxid aufweist, der um mindestens 5 Gew.-ppm, bevorzugt um mindestens 10 Gew.-ppm höher ist als der Gehalt an Aluminiumoxid im Quarzglas der zweiten Quarzglasqualität. Daher kann einem Quarzglas, das für Bauteile konzipiert ist, die bei hoher Temperatur eingesetzt werden und die eine gewisse Temperaturstabilität aufweisen sollen, Aluminiumoxid zwecks Viskositätserhöhung beigefügt werden. Auch die Viskosität von synthetisch erzeugtem Quarzglas kann so erhöht werden.

Natürlich vorkommender Rohstoff für Quarzglas enthält häufig einen gewissen Anteil an Aluminiumoxid. Im Hinblick darauf wird das Quarzglas der ersten Quarzglasqualität bevorzugt aus einem natürlich vorkommenden Rohstoff erschmolzen. Die Kosten für die Herstellung des Substratrohre aus natürlichem Quarzglas sind vergleichsweise niedrig. Beispielsweise können solche Substratrohre anhand der bekannten Tiegelziehverfahren kostengünstig hergestellt werden.

Das Quarzglas der zweiten Quarzglasqualität ist beispielsweise hochreines, synthetisch erzeugtes Quarzglas ohne einen nennenswerten Anteil an Aluminiumoxid oder mit einem geringen Anteil an Aluminiumoxid von weniger als 1 Gew.-ppm, bevorzugt weniger als 0,5 Gew.-ppm.

Demgegenüber enthält das Quarzglas der ersten Quarzglasqualität vorzugsweise mindestens 5 Gew.-ppm, bevorzugt mindestens 10 Gew.-ppm. Ein Aluminiumoxidanteil von mehr als 100 Gew.-ppm ist aber im Allgemeinen nicht bevorzugt.

Die Viskosität von Quarzglas kann auch durch Hydroxylgruppen verändert werden. Hydroxylgruppen können die Viskosität von Quarzglas absenken. Im Hinblick darauf ist bei einer bevorzugten Verfahrensweise vorgesehen, dass das Quarzglas der ersten Quarzglasqualität einen Hydroxylgruppengehalt von weniger als 30 Gew.-ppm und vorzugsweise einen Hydroxylgruppengehalt von weniger als 20 Gew.-ppm.

Hydroxylgruppengehalte von weniger als 30 Gew.-ppm sind bei einer aus natürlichem Rohstoff erzeugten Quarzglasqualität beispielsweise durch Einschmelzen des Rohstoffs in einem elektrisch beheizten Ofen oder unter Einsatz eines wasserstofffreien Plasmas erreichbar. Der Hydroxylgruppengehalt von synthetisch über die SiO₂-Soot-Route erzeugtem Quarzglas, ist in weitem Rahmen über die Trocknung des Sootkörpers vor dem Verglasen einstellbar. Durch diese Trocknungsbehandlung sind auch in synthetisch erzeugtem Quarzglas geringe Hydroxylgruppengehalte im Bereich weniger Gew.-ppm erreichbar, die sich durch eine vergleichsweise niedrige Viskosität auszeichnen. Gegebenenfalls ist hydroxylgruppenarmes synthetisches Quarzglas als Substratrohr-Material geeignet, sofern das Quarzglas des darauf aufgebrachten Sootkörpers eine vergleichsweise geringe Viskosität aufweist.

Bei einer bevorzugten Verfahrensweise wird ein Substratrohr eingesetzt, das eine Wanddicke im Bereich von 1,5mm bis 10mm, vorzugsweise im Bereich von 4 bis 8mm aufweist.

Die Wanddicke ist so groß wie nötig, um die gewünschte thermische Stabilität zu gewährleisten. Andererseits ist die Wanddicke so klein wie möglich, da das Material des Substratrohres bei der Weiterverarbeitung des Quarzglas-Verbundkörpers in der Regel entfernt wird.

Der nach dem Verglasen dieses Verbunds aus Substratrohr und SiO₂-Sootschicht erhaltene Quarzglas-Verbundkörper weist einen inneren Wandungsbereich aus dem Quarzglas der ersten Qualität auf, das aus dem ehemaligen Substratrohr stammt. Und er weist einen äußeren Wandungsbereich aus dem Quarzglas der zweiten Qualität auf, das aus dem ehemaligen Sootkörper resultiert. Die Dicke des äußeren Wandungsbereichs skaliert mit der Wanddicke des Sootkörpers und der Sootdichte
Die Sootdichte liegt typischerweise im Bereich von 25 bis 33% der Dichte von Quarzglas. Im Hinblick darauf ist der nach dem Außenabscheideverfahren erhaltene Sootkörper vorteilhafterweise im Wesentlichen zylinderförmig ausgebildet und er hat vorzugsweise eine Wanddicke, die nach dem Sintern des Verbundkörpers eine Glasschicht ergibt, die eine Schichtdicke im Bereich von 25mm bis 100mm, bevorzugt im Bereich von 30mm bis 60mm, aufweist.

Hinsichtlich des rohrförmigen Quarzglas-Verbundkörpers wird die oben angegebene technische Aufgabe ausgehend von einem Verbundkörper der eingangs genannten Gattung erfindungsgemäß dadurch gelöst, dass die Rohwandung einen inneren Wandungsbereich und einen äußeren Wandungsbereich umfasst, wobei der innere Wandungsbereich mindestens teilweise aus Quarzglas einer ersten Quarzglasqualität besteht, und der äußere Wandungsbereich aus Quarzglas einer zweiten Quarzglasqualität besteht, wobei bei einer Messtemperatur von 1350°C die Viskosität der ersten Quarzglasqualität höher ist als die Viskosität der zweiten Quarzglasqualität.

Der rohrförmige Quarzglas-Verbundkörper ist anhand des oben erläuterten Verfahrens gemäß der Erfindung herstellbar. Der äußere Wandungsbereich des Quarzglas-Verbundkörpers wird gegebenenfalls von Quarzglas gebildet, das durch Sintern eines ehemaligen SiO₂-Sootkörpers erhalten worden ist, und der innere Wandungsbereich wird vom Quarzglas des ehemaligen Substratrohres gebildet.

Da sowohl der innere Wandungsbereich als auch der äußere Wandungsbereich aus Quarzglas bestehen, unterscheiden sie sich in ihren thermischen Ausdehnungskoeffizienten nicht oder nicht nennenswert. Beim vorherigen Sintern ist der Sootkörper am Substratrohr angesintert, so dass eine gewisse Haftung im Verbundkörper gewährleistet ist.

Die vergleichsweise höhere Viskosität des inneren Wandungsbereichs wird beispielsweise dadurch erreicht, dass er über mindestens einen Teil seiner Länge und/oder mindestens über einen Dickenbereich aus einem Quarzglas besteht, das bei der Messtemperatur von 1350°C eine höhere Viskosität aufweist als das synthetische Quarzglas des äußeren Wandungsbereichs.

Es hat sich bewährt, wenn bei einer Messtemperatur von 1350°C der dekadische Logarithmus der Viskosität der ersten Quarzglasqualität um mindestens 0,25 Ig(dPa·s), vorzugsweise um mindestens 0,4 lg(dPa·s) besonders bevorzugt um mindestens 0,6 lg(dPa·s) höher ist als der des Quarzglases der zweiten Quarzglasqualität. Die Viskositätsunterschiede werden hier als Differenz des dekadischen Logarithmus lg(dPa·s) der jeweiligen Viskositätswerte angegeben. Größere Viskositätsunterschiede als 1 lg(dPa·s) bei der Messtemperatur sind in der Regel nicht erforderlich.

Der innere Wandungsbereich kann ein Halteelement aufweisen, das beim vorherigen Sinterprozess eine hängende Verglasung unter Bildung des Quarzglas-Verbundkörpers ermöglicht hat. Bei einer bevorzugten Ausführungsform besteht das Quarzglas des inneren Wandungsbereichs nur über einen Teil seiner Länge aus einem höherviskosen Quarzglas, beispielsweise in dem Teil seiner Länge, in dem sich das Halteelement befindet.

Im einfachsten und besonders bevorzugten Fall besteht der innere Wandungsbereich vollständig aus dem Quarzglas der ersten Quarzglasqualität, also dem höherviskosen Quarzglas.

Die Viskosität von Quarzglas kann durch Versteifung von dessen Glas-Netzwerkstruktur und insbesondere durch Dotierstoffe verändert werden. Eine Versteifung der Glas-Netzwerkstruktur kann durch Sauerstoffdefektzentren (auch bekannt als "ODC-Zentren" - Oxygen Deficiency Centers) erreicht werden. Stickstoff, Titanoxid und Aluminiumoxid sind Dotierstoffe, die geeignet sind, die Viskosität von Quarzglas zu erhöhen.

Im Hinblick darauf ist bei einer bevorzugten Ausführungsform des Verbundkörpers vorgesehen, dass das Quarzglas der ersten Quarzglasqualität einen Gehalt an Aluminiumoxid aufweist, der um mindestens 5 Gew.-ppm, bevorzugt um mindestens 10 Gew.-ppm höher ist als der Gehalt an Aluminiumoxid im Quarzglas der zweiten Quarzglasqualität. Daher kann einem Quarzglas, das für Bauteile konzipiert ist, die bei hoher Temperatur eingesetzt werden und die eine gewisse Temperaturstabilität aufweisen sollen, Aluminiumoxid zwecks Viskositätserhöhung beigefügt werden. Auch die Viskosität von synthetisch erzeugtem Quarzglas kann so erhöht werden.

Natürlich vorkommender Rohstoff für Quarzglas enthält häufig einen gewissen Anteil an Aluminiumoxid. Im Hinblick darauf wird das Quarzglas der ersten Quarzglasqualität bevorzugt aus einem natürlich vorkommenden Rohstoff erschmolzen. Die Kosten für die Herstellung von natürlichem Quarzglas sind vergleichsweise niedrig.

Das Quarzglas der zweiten Quarzglasqualität ist beispielsweise hochreines, synthetisch erzeugtes Quarzglas ohne einen nennenswerten Anteil an Aluminiumoxid oder mit einem geringen Anteil an Aluminiumoxid von weniger als 1 Gew.-ppm, bevorzugt weniger als 0,5 Gew.-ppm.

Demgegenüber enthält das Quarzglas der ersten Quarzglasqualität vorzugsweise mindestens 5 Gew.-ppm, bevorzugt mindestens 10 Gew.-ppm. Ein Aluminiumoxidanteil von mehr als 100 Gew.-ppm ist aber im Allgemeinen nicht bevorzugt.

Die Viskosität von Quarzglas kann auch durch Hydroxylgruppen verändert werden. Hydroxylgruppen können die Viskosität von Quarzglas absenken. Im Hinblick darauf ist bei einer bevorzugten Ausführungsform des Verbundkörpers vorgesehen, dass das Quarzglas der ersten Quarzglasqualität einen Hydroxylgruppengehalt von weniger als 30 Gew.-ppm und vorzugsweise einen Hydroxylgruppengehalt von weniger als 20 Gew.-ppm aufweist.

Hydroxylgruppengehalte von weniger als 30 Gew.-ppm sind bei einer aus natürlichem Rohstoff erzeugten Quarzglasqualität beispielsweise durch Einschmelzen des Rohstoffs in einem elektrisch beheizten Ofen oder unter Einsatz eines wasserstofffreien Plasmas erreichbar. Der Hydroxylgruppengehalt von synthetisch über die SiO₂-Soot-Route erzeugtem Quarzglas, ist in weitem Rahmen über die Trocknung des Sootkörpers vor dem Verglasen einstellbar. Durch diese Trocknungsbehandlung sind auch in synthetisch erzeugtem Quarzglas geringe Hydroxylgruppengehalte im Bereich weniger Gew.-ppm erreichbar, die sich durch eine vergleichsweise niedrige Viskosität auszeichnen. Gegebenenfalls ist hydroxylgruppenarmes synthetisches Quarzglas als Substratrohr-Material geeignet, sofern das Quarzglas des darauf aufgebrachten Sootkörpers eine vergleichsweise geringe Viskosität aufweist.

Bei einer bevorzugten Ausführungsform des Verbundkörpers weist der innere Wandungsbereich aus dem Quarzglas der ersten Qualität eine Wanddicke im Bereich von 1,5mm bis 10mm, vorzugsweise im Bereich von 4 bis 8mm auf.

Die Wanddicke ist so groß wie nötig, um die gewünschte thermische Stabilität zu gewährleisten. Andererseits ist die Wanddicke so klein wie möglich, da das Quarzglas der ersten Qualität bei der Weiterverarbeitung des Verbundkörpers in der Regel entfernt wird.

Bei einer bevorzugten Ausführungsform des Verbundkörpers weist der äußere Wandungsbereich eine Wanddicke im Bereich von 25mm bis 100mm, vorzugsweise im Bereich von 30mm bis 60mm auf.

Aus dem Quarzglas-Verbundkörper wird ein Quarzglas-Hohlzylinder gefertigt, indem der innere Wandungsbereich entfernt wird, beispielsweise durch Bohren, Fräsen oder Ätzen. Das so erhaltene Quarzglas-Hohlzylinder wird zur Herstellung von Ätzringen für Single-Wafer Plasmaätzkammern oder von Druckgefäßen zum Einsatz in der chemischen Verfahrenstechnik verwendet.

Die Ätzringe beziehungsweise Druckgefäße haben einen vorgegebenen Soll-Innendurchmesser. Für die Herstellung der Ätzringe beziehungsweise Druckgefäße wird vorzugsweise ein Verbundkörper mit einem äußeren Wandungsbereich mit einem Innendurchmesser eingesetzt, der um mindestens 1mm kleiner ist als der Soll-Innendurchmesser. Der Soll-Innendurchmesser wird dabei durch Entfernen des gesamten inneren Wandungsbereichs und eines Übermaßes am äußeren Wandungsbereichs eingestellt, wobei das Übermaß 1mm oder mehr beträgt.

### Definitionen und Messmethoden

Einzelne Begriffe der obigen Beschreibung werden im Folgenden ergänzend definiert. Die Definitionen sind Bestandteil der Beschreibung der Erfindung. Für Begriffe und Messverfahren, die in der Beschreibung nicht speziell definiert sind, ist die Auslegung gemäß der Internationalen Fernmeldeunion (ITU; International Telecommunication Union) maßgeblich. Bei einem Widerspruch zwischen einer der folgenden Definitionen und der übrigen Beschreibung ist das in der übrigen Beschreibung Gesagte maßgeblich.

### Rohrförmiger Verbundkörper aus Quarzglas

Ergebnis des Abscheideverfahrens ist ein rohrförmiger Verbund aus einem Substratrohr aus Quarzglas und einem SiO₂-Sootkörper. Das Substratrohr begrenzt die Innenbohrung des Verbunds. Durch Sintern (Verglasen) des Sootkörpers wird ein rohrförmiger Verbundkörper aus Quarzglas erhalten. Durch nachträgliches Entfernen des Substratrohres aus dem Quarzglas-Verbundkörper wird ein Quarzglas-Hohlzylinder erhalten. Das Entfernen des Substratrohres erfolgt beispielsweise durch Herausbohren. Durch mechanische, thermische oder chemische Weiterbearbeitung werden aus dem Quarzglas-Hohlzylinder Bauteile aus Quarzglas erzeugt. Die mechanische Weiterbearbeitung umfasst Bohren, Sägen, Schneiden, Fräsen, Schleifen und Polieren der Innen- und Außenkonturen. Die thermische Weiterbearbeitung umfasst thermisches Trocknen, Sintern, Verglasen, Schmelzen, Umformen und Tempern. Die chemische Weiterbearbeitung umfasst Dotieren und Ätzen. Das Bauteil aus Quarzglas ist ein einsatzbereites Quarzglasprodukt oder ein Halbzeug dafür, beispielsweise ein Quarzglas-Hohlzylinder zur Herstellung eines Druckgefäßes oder ein Quarzglasring zur Herstellung eines Halterings für Wafer.

### Quarzglas / synthetisches Quarzglas

Unter Quarzglas wird hier Glas mit einem SiO₂-Anteil von mindestens 87 Gew-% verstanden. Es ist undotiert (SiO₂-Gehalt = 100%) oder es enthält Dotierstoffe, wie beispielsweise Fluor, Chlor, Stickstoff, Kohlenstoff oder Oxide von Bor, Germanium, Seltenerdmetallen, Aluminium oder Titan.

Quarzglas ist beispielsweise aus natürlich vorkommendem SiO₂-Rohstoff erschmolzen (natürliches Quarzglas), oder es ist synthetisch erzeugt (synthetisches Quarzglas) oder es besteht aus Mischungen dieser Quarzglassorten.

### Sintern / Verglasen

Mit "Sintern" oder "Verglasen" wird hier ein Verfahrensschritt bezeichnet, bei dem ein Sootkörper aus porösem Siliziumdioxid in einem Ofen bei hoher Temperatur behandelt wird. Das Sintern/Verglasen erfolgt Inertgas, einer Wasserstoff und/oder Helium enthaltenden Atmosphäre oder unter Vakuum.

### Vakuum

Das Verglasen des Verbundkörpers kann unter "Vakuum" erfolgen. Der Unterdruck wird als absoluter Gasdruck angegeben. Unter Vakuum wird ein absoluter Gasdruck von weniger als 50 mbar verstanden.

### Substratrohr-Außendurchmesser / Substratrohr-Innendurchmesser

Der Substratrohr-Querschnitt hat eine kreisrunde Außenkontur oder eine von der Rundform abweichende Außenkontur. Bei einer von der Rundform abweichenden Außenkontur ergibt sich der lokale "Außendurchmesserwert" aus dem Durchmesser des (kleinsten) Umkreises.

Der Substratrohr-Querschnitt hat eine kreisrunde Innenkontur oder eine von der Rundform abweichende Innenkontur. Bei einer von der Rundform abweichenden Innenkontur ergibt sich der lokale "Innendurchmesserwert" aus dem Durchmesser des (größten) Inkreises.

Im Substratrohr-Längsschnitt sind die lokalen Werte für den Außendurchmesser über die Gesamtlänge des Substratrohres konstant oder sie sind nicht konstant. Bei konstanten Außendurchmesser-Werten hat das Substratrohr von außen gesehen Zylinderform. Die nicht-konstanten Außendurchmesser-Werte können über die Gesamtlänge oder über eine Teillänge variieren. Die Außenkontur kann sich beispielsweise kontinuierlich oder stufenweise verändern. Der Außendurchmesser ergibt sich in dem Fall aus den über die Gesamtlänge gemittelten lokalen Außendurchmesser-Werten.

Im Substratrohr-Längsschnitt sind die lokalen Werte für den Innendurchmesser über die Gesamtlänge des Substratrohres konstant oder sie sind nicht konstant. Bei konstanten Innendurchmesser-Werten ist die Durchgangsöffnung des Substratrohr zylindrisch. Die nicht-konstanten Innendurchmesser-Werte können über die Gesamtlänge oder über eine Teillänge variieren. Die Innenkontur kann sich beispielsweise kontinuierlich oder stufenweise verändern. Der Innendurchmesser ergibt sich in dem Fall aus den über die Gesamtlänge gemittelten lokalen Innendurchmesser-Werten.

### Viskosität

Die Messung der "Viskosität" des Quarzglases erfolgt mittels Balkenbiegeviskosimeter. Die Balkenbiegeviskosimetrie deckt einen Viskositätsbereich von 10⁸ bis 10¹⁵ dPa·s ab (in logarithmischen Einheiten: von 8 lg(dPa·s) bis 15 lg dPa·s. Der Messaufbau umfasst eine beheizbare Dreipunktbiegevorrichtung mit einem Messbalken aus dem zu messenden Quarzglas (Balken/Streifen: 50mm lang, 3mm hoch, 5mm breit). Die Messgröße ist die Durchbiegegeschwindigkeit bei der jeweiligen Temperatur.

Anstelle in der Exponentialschreibweise werden Viskositätswerte häufig auch anhand des dekadischen Logarithmus in der Form lg(dPa·s) angegeben.

### Erweichungstemperatur

Gläsern kann eine scharfe Erweichungstemperatur nicht zugeordnet werden, sondern ein Erweichungstemperaturbereich. Zwecks Festlegung eines Temperaturwertes wird vorliegend auf die Bestimmung nach DIN ISO 7884 (1998) Bezug genommen, gemäß der die Erweichungstemperatur als diejenige Temperatur definiert ist, bei der das Glas eine Viskosität von 10^{7,6} dPa·s (7,6 lg (dPas)) aufweist. Für die Erweichungstemperatur von undotiertem Quarzglas werden in der Literatur Temperaturwerte im Bereich von 1600°C bis 1730°C genannt.

### Ausführungsbeispiel

Nachfolgend wird die Erfindung anhand von Ausführungsbeispielen und einer Patentzeichnung näher erläutert. Im Einzelnen zeigt in schematischer Darstellung
- **Figur 1**: eine Vorrichtung zur Herstellung eines Verbundkörpers aus Substratrohr und Sootkörper in einer ersten Ausführungsform einer Substratrohrhalterung in einem Längsschnitt,
- **Figur 2**: eine Vorrichtung zur Herstellung eines Verbundkörpers aus Substratrohr und Sootkörper in einer zweiten Ausführungsform einer Substratrohrhalterung in einem Längsschnitt, teilweise als Ausschnitt,
- **Figur 3**: einen Ausschnitt der Substratrohrhalterung von Figur 2 in vergrößerter Darstellung,
- **Figur 4**: Bestandteile eines Zonensinterofens, wie er zum Verglasen eines Verbundkörpers eingesetzt wird,
- **Figur 5**: das Verglasen eines stehenden Verbundkörpers unter Einsatz des Zonensinterofens,
- **Figur 6**: einen Verfahrensschritt zum Erzeugen einer ersten Ausführungsform einer Haltekante am Substratrohr,
- **Figur 7**: einen weiteren Verfahrensschritt zum Erzeugen der Haltekante am Substratrohr,
- **Figur 8**: das Verglasen eines teilweise hängenden Verbundkörpers mittels der ersten Ausführungsform der Haltekante am Substratrohr im Zonensinterofen,
- **Figur 9**: einen Verfahrensschritt zum Erzeugen einer zweiten Ausführungsform einer Haltekante am Substratrohr,
- **Figur 10**: einen weiteren Verfahrensschritt zum Erzeugen der Haltekante am Substratrohr,
- **Figur 11**: eine Ausführungsform eines Substratrohres mit einer vor dem Außenabscheideverfahren erzeugten Haltekante in Form einer Verjüngung seines Innendurchmessers,
- **Figur 12**: das Substratrohr von Figur 11 nach Abschluss des Außenabscheideverfahrens beim Verglasen des Verbundkörpers im Zonensinterofen von Figur 4, und
- **Figur 13**: ein Ausführungsbeispiel für einen rohrförmigen Quarzglas-Verbundkörper gemäß der Erfindung in einem Längsschnitt.

Bei den nachfolgend erläuterten Ausführungsbeispielen werden unterschiedliche Substratrohre eingesetzt, von denen einige Eigenschaften in Tabelle 1 zusammengefasst sind.

**Tabelle 1 - Substratrohre**

| **Nr** | **Material** | **Viskosität [lg(dPa·s) bei 1350°C]** | **OH-Gehalt [Gew.-ppm]** | **Außen-durch-messer [mm]** | **Innen-durch-messer [mm]** | **Länge [mm]** | **Form** |
|---|---|---|---|---|---|---|---|
| 1 | Natürliches Quarzglas (elektrisch geschmolzen) | 11,28 | 20-30 | 280 | 270 | 2000 | Zylinder |
| 2 | Natürliches Quarzglas (elektrisch geschmolzen) | 11,28 | 20-30 | 280 | 270 | 1500 | Zylinder mit Verengung |
| 3 | Synthetisches Quarzglas (thermisch getrocknet) | 10,77 | 200 | 280 | 270 | 1500 | Zylinder mit Verengung |
| 4 | Synthetisches Quarzglas (mit Chlor getrocknet) | 10,64 | <0,2 | 280 | 270 | 1500 | Zylinder mit Verengung |

"Natürliches Quarzglas" ist aus natürlich vorkommendem SiO₂-Rohstoff erschmolzen, vorzugsweise in einem elektrischen beheizten Schmelzofen. Eine besonders kostengünstige Herstellung des Substratrohres aus natürlichem Quarzglas erfolgt anhand eines Vertikal-Tiegelziehverfahrens. Dieses Quarzglas enthält typischerweise Aluminiumoxid in einer Konzentration im Bereich von zwischen 6 Gew.-ppm und 18 Gew.-ppm und Hydroxylgruppen in einer Konzentration von weniger als 50 Gew.-ppm.

"Synthetisches Quarzglas" wird beispielsweise durch Flammenhydrolyse oder Oxidation synthetisch erzeugter Siliziumverbindungen, durch Polykondensation organischer Siliziumverbindungen nach dem so genannten Sol-Gel-Verfahren oder durch Hydrolyse und Fällung anorganischer Siliziumverbindungen in einer Flüssigkeit erhalten. Die Viskosität von synthetischem Quarzglas hängt von seiner Zusammensetzung ab, die in einem weiten Bereich variieren kann. Ganz allgemein kann man jedoch sagen, dass synthetisches Quarzglas typischerweise eine deutlich niedrigere Viskosität hat als natürliches Quarzglas.

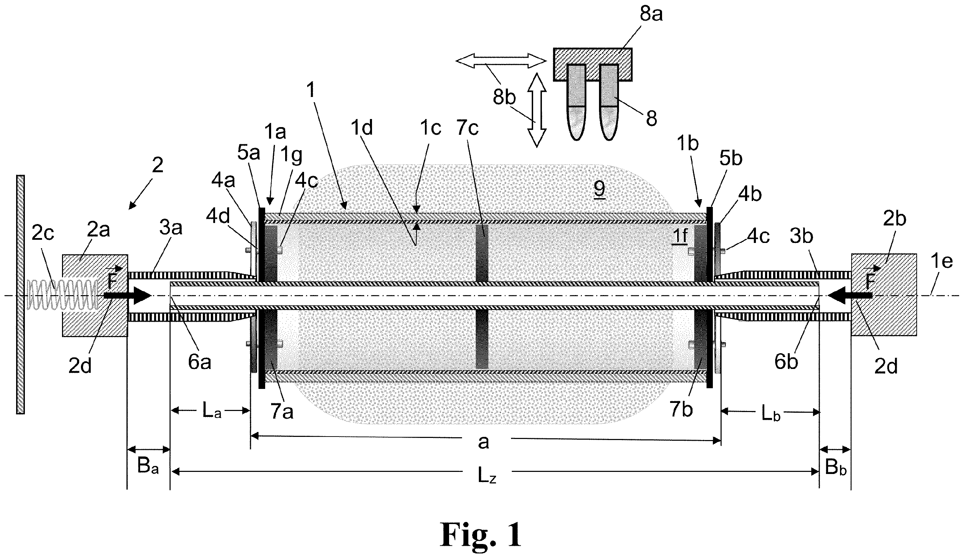

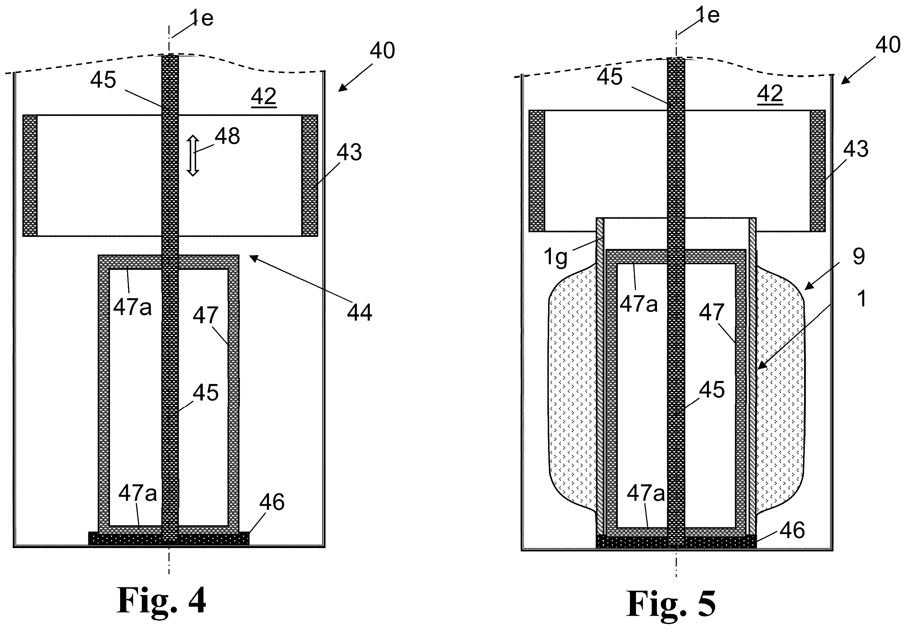

Die in **Figur 1** schematisch dargestellte Vorrichtung dient zur Herstellung eines großvolumigen Verbunds aus einem Substratrohr 1 und einem SiO₂-Sootkörper 9. Sie umfasst eine Glasdrehbank 2 zur Halterung und Rotation des Substratrohres 1 entsprechend der Nummer 1 aus Tabelle 1. Das Substratrohr 1 hat eine linke Stirnseite 1a, eine rechte Stirnseite 1b, eine Außenmantelfläche 1c, eine Innenmantelfläche 1d, eine horizontal orientierte Längsachse 1e und eine zylindrische Durchgangsbohrung 1f. Angrenzend an das stirnseitige Ende 1a befindet sich ein freier Substratrohr-Abschnitt 1g, auf dem beim Sootabscheideprozess eine reduzierte Abscheidung von SiO₂-Sootpartikeln stattfindet. Der freie Substratrohr-Abschnitt 1g kann während des Verglasens zu einer Haltekante umgeformt werden, was weiter unten anhand der Figuren 4 und 6 bis 10 noch näher erläutert wird.

Die Glasdrehbank 2 ist angedeutet durch zwei sich gegenüberliegende Spannfutter 2a, 2b, von denen das Spannfutter 2a federgelagert ist, wie dies die Druckfeder 2c anzeigt. Mittels der Druckfeder 2c wird eine Druckkraft F erzeugt, die die beiden Spannfutter 2a, 2b gegeneinanderdrückt, wie von den Richtungspfeilen 2d angedeutet.

In den Spannfuttern 2a, 2b ist mit ihrem proximalen Ende jeweils eine Hohlspindel 3a, 3b aus Edelstahl eingespannt. Die Rotationsachsen der Hohlspindeln 3a, 3b verlaufen im Idealfall koaxial zur Substratrohr-Längsachse 1e. Die Hohlspindeln 3a, 3b haben einen Außendurchmesser von 90mm und einen Innendurchmesser von 82mm.

Die distalen Enden der Hohlspindeln 3a, 3b sind schwenkbeweglich mit jeweils einer ringförmigen Druckplatte 4a, 4b aus Edelstahl verbunden. Zu diesem Zweck verjüngen sich die distalen Enden der Hohlspindeln 3a, 3b konisch und drücken infolge der Kraft der Feder 2c gegen die jeweilige Druckplatte 4a, 4b. Dabei ragt das konische Ende in eine Mittenbohrung der jeweiligen ringförmigen Druckplatte 4a, 4b hinein und liegt am Innenrand der Mittenbohrung an.

Die Druckplatten 4a, 4b liegen jeweils an Pufferscheiben 5a, 5b aus Grafit an, und diese wiederum an den Substratrohr-Stirnseiten 1a beziehungsweise 1b. Die Pufferscheiben 5a, 5b haben eine Mittenbohrung, deren Durchmesser denen der Druckplatten entspricht und die koaxial zu diesen verlaufen. Die Druckplatten 4a, 4b haben einen Außendurchmesser, der um 10mm kleiner ist als der Außendurchmesser des Substratrohres 1. Die Pufferscheiben 5a, 5b haben einen Außendurchmesser, der den Außendurchmesser des Substratrohres 1 um 40mm überragt.

Durch die Substratrohr-Durchgangsbohrung 1f sowie durch die Mittenbohrungen von Druckplatten 4a, 4b und Pufferscheiben 5a, 5b erstreckt sich ein rohrförmiger Zentrierträger 6 aus SiSiC mit einer Gesamtlänge L_{z} und mit einem Außendurchmesser von 80 mm. Ein Ende 6a des Zentrierträgers 6 ragt über eine Länge Lₐ von 500mm in die Hohlspindel 3a hinein und endet innerhalb dieser unter Belassung eines variablen Bewegungsspielraums Bₐ von etwa 6mm. Das andere Ende 6b ragt über eine Länge L_{b} von 600mm in die Hohlspindel 3b hinein und endet innerhalb dieser unter Belassung eines variablen Bewegungsspielraums B_{b} von ebenfalls etwa 6mm. Der gesamte Bewegungsspielraum B_{z}=Bₐ+B_{b} für den Zentrierträger 6 innerhalb der Hohlspindeln 3a, 3b ist somit 12mm. Der Außendurchmesser des Zentrierträgers 6 ist über seine Länge konstant und mit Spielpassung an den Innendurchmesser der Hohlspindeln 3a, 3b angepasst und darin teleskopartig verschiebbar.

Auf den Zentrierträger 6 sind drei Zentrierringe 7a, 7b, 7c aus Grafit aufgesetzt. Der Zentrierring 7a befindet sich im Bereich der linken Substratrohr-Stirnseite 1a, der Zentrierring 7b befindet sich im Bereich der rechten Substratrohr-Stirnseite 1b, und der Zentrierring 7c befindet sich etwa in der Mitte der Substratrohr-Durchgangsbohrung 1f. Alle Zentrierringe 7a, 7b, 7c haben einen Außendurchmesser, der mit Spielpassung an den Substratrohr-Innendurchmesser angepasst ist, und sie haben einen Innendurchmesser der mit Spielpassung an den Zentrierträger-Außendurchmesser angepasst ist.

Der endständige Zentrierring 7a, die Pufferscheibe 5a und die Druckscheibe 4a sind mittels Schrauben 4c locker miteinander verbunden. Die Schrauben 4c haben ein Gewinde, das an einen Zylinderabschnitt 4d angrenzt. Das Schrauben-Gewinde greifen jeweils in ein Innengewinde in der Druckscheibe 4a ein, so dass der Zylinderabschnitt 4d im angezogenen Zustand an der Druckscheibe 4a fest anliegt. Die Länge des Zylinderabschnitts 4d ist größer als die Gesamtdicke des Komponentenstapels aus Zentrierring 7a und Pufferscheibe 5a, so dass die Köpfe der Schrauben 4c nicht am Zentrierring 7a anliegen, sondern ein Spalt zwischen dem Zentrierring 7a und den Schraubenköpfen verbleibt. Außerdem sind die Durchgangsbohrungen für den Durchlass des Zylinderabschnitts 4d in der Pufferscheibe 5a und im Zentrierring 7a größer als der Durchmesser des Zylinderabschnitts 4d, so dass die Schrauben 4c auch leicht schräg in den Durchgangsbohrungen stehen können. Diese lockere Verbindung ist daher geeignet, sowohl thermisch bedingte Längenänderungen zwischen Komponenten der Substratrohrhalterung zuzulassen als auch Abweichungen in SollAbmessungen, -Positionierungen und -Ausrichtungen der Komponenten zu kompensieren. Außerdem bewirken die Schrauben 4c eine gewisse Verdrehfestigkeit zwischen der Pufferscheibe 5a und der Druckscheibe 4a bei der Rotationsbewegung des Substratrohres 1 und dienen insoweit als Mitnehmerelemente für diese Rotationsbewegung. Das Gleiche gilt für die Verbindung des Zentrierrings 7b, der Pufferscheibe 5b und der Druckscheibe 4b. Zwischen dem Zentrierring 7a, 7b und der Pufferscheibe 5a, 5b ist zwecks thermischer Entkopplung ein Spalt vorgesehen (in der Figur nicht erkennbar).

Mehrere Abscheidebrenner 8 zur Erzeugung von SiO₂-Partikeln sind auf einem gemeinsamen Schlitten 8a montiert, mittels dem sie entlang der Außenmantelfläche 1c des Substratrohres 1 beziehungsweise entlang eines sich ausbildenden SiO₂-Sootkörpers 9 reversierend und transversal bewegbar und senkrecht dazu verschiebbar sind, wie dies die Richtungspfeile 8b andeuten.

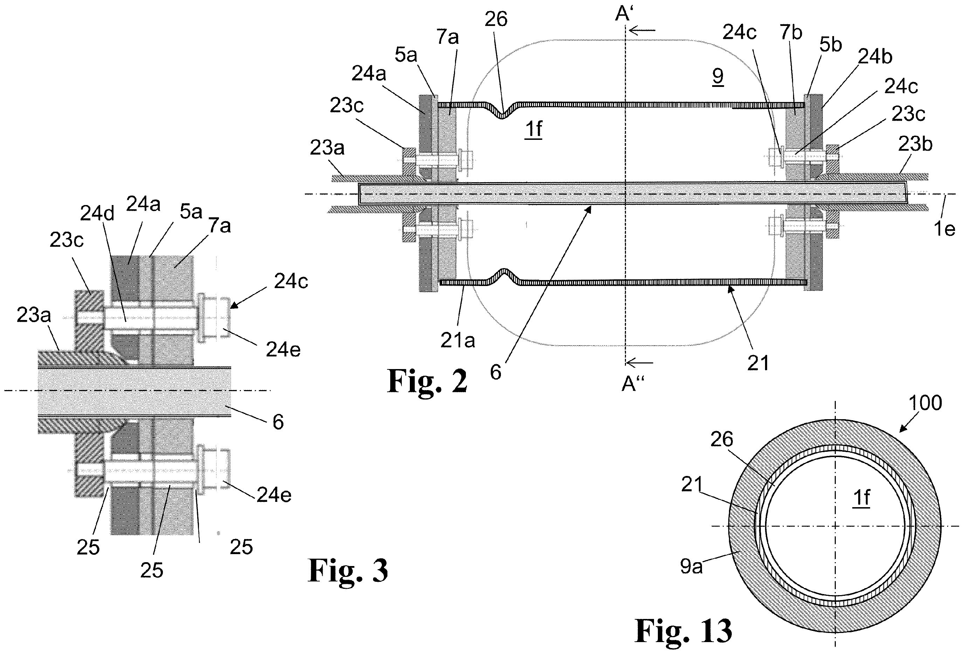

Sofern in Figur 2 und in Figur 3 die gleichen Bezugsziffern wie in Figur 1 verwendet sind, so bezeichnen diese identische oder äquivalente Bauteile oder Bestandteile der Vorrichtung.

Die in **Figur 2** schematisch dargestellte Vorrichtung unterscheidet sich von der von Figur 1 im Wesentlichen in der Art und Weise der Substratrohrhalterung und dem Substratrohr 21. Sofern die gleichen Bezugsziffern verwendet werden wie in Figur 1, so bezeichnen diese identische oder äquivalente Bauteile oder Bestandteile der anhand Figur 1 erläuterten Vorrichtung.

Das Substratrohr 21 entspricht der Nummer 2 aus Tabelle 1. In einem Endbereich 21a hat es eine umlaufende Verengung 26 seines Innendurchmessers. Die Verengung 26 wird vor Beginn des Außen- Abscheideverfahren erzeugt, beispielsweise durch lokales Erweichen des Substratrohres 21 nach dem Einspannen in die Glasdrehbank 2. Die Verengung 26 befindet sich im Abstand von etwa 80mm vor der Substratrohr-Stirnseite. Der Innendurchmesser beträgt 270mm, ausgenommen im Bereich der Verengung 26, wo er 250mm beträgt.

Die jeweils in Spannfuttern mit ihrem proximalen Ende eingespannten Hohlspindeln 23a, 23b bestehen aus Edelstahl. Die Rotationsachsen der Hohlspindeln 23a, 23b verlaufen im Idealfall koaxial zur Substratrohr-Längsachse 1e. Die Hohlspindeln 23a, 23b haben einen Außendurchmesser von 100mm. Im Bereich der distalen Enden der Hohlspindeln 23a, 23b ist jeweils ein umlaufender Ausleger 2c angeschweißt.

Die schwenkbewegliche Verbindung zwischen den Hohlspindeln 23a, 23b und den jeweiligen Druckplatten 24a, 24 ist hier als Loslager ausgebildet und umfasst vorzugsweise einen kardanischen Kugel-Kegelsitz. Dabei bilden die distalen Enden der Hohlspindeln 23a, 23b jeweils einen konvex gekrümmten Sitz, der einen Kugel- oder Radienabschnitt aufweist, auf dem die Druckplatte 24a beziehungsweise die Druckplatte 24b beweglich gelagert ist, indem sie einen mit dem konvex gekrümmten Sitz zusammenwirkenden konkav gekrümmten Kugel- oder Radienabschnitt aufweist.

**Figur 3** zeigt die schwenkbewegliche Verbindung zwischen den Hohlspindeln 23a, 23b und den jeweiligen Druckplatten 24a, 24b in einer vergrößerten Darstellung. Der endständige Zentrierring 7a, die Pufferscheibe 5a und die Druckscheibe 24a bilden einen Komponentenstapel, der mittels Gewindeschrauben 24c, die jeweils in ein Gewinde im Ausleger 23c eingreifen, lose miteinander verbunden sind. Der Zylinderabschnitt 24d hat dabei eine Länge, die größer ist als die Gesamtdicke des Komponentenstapels aus Zentrierring 7a, Pufferscheibe 5a und Druckscheibe 24a. Außerdem ist die Weite der Bohrung zur Aufnahme der Gewindeschrauben 24c im Komponentenstapel deutlich größer als der Durchmesser des Zylinderabschnitts 24d. Dies führt dazu, dass auch bei fest angezogener Gewindeschraube 24c sowohl zwischen dem Schraubenkopf 24e und dem Zentrierring 7a, als auch zwischen der Druckplatte 24 und dem Ausleger 23c, als auch entlang des Zylinderabschnitt 24d mehrere Spalte 25 verbleiben. Die Spalte 25 stellen sicher, dass die Verbindung zwischen den Hohlspindeln 23a, 23b und den jeweiligen Druckplatten 24a, 24b schwenkbeweglich bleibt. Gleichzeitig dienen die Schrauben 24c als Mitnehmerelemente für die Rotationsbewegung des Substratrohres 1.

Nachfolgend werden anhand der Figuren 1 und 4 bis 10 Beispiele zur Herstellung eines Quarzglas-Verbundkörpers erläutert.

### Sootabscheideprozess

Den Abscheidebrennern 8 werden jeweils als Brennergase Sauerstoff und Wasserstoff zugeführt sowie als Einsatzmaterial für die Bildung von SiO₂-Partikeln ein Gasstrom, der SiCl₄ oder ein anderes siliziumhaltiges Ausgangsmaterial enthält. Diese Komponenten werden in der jeweiligen Brennerflamme zu SiO₂-Partikeln umgesetzt und diese SiO₂-Partikel werden auf dem um die Längsachse 1e rotierenden Substratrohr 1 unter Bildung des Sootkörpers 9 aus porösem SiO₂-Soot abgeschieden.

Zur Rotation des Substratrohres 1 überträgt die Glasdrehbank 2 ein Drehmoment auf die Hohlspindeln 2a, 2b. Gleichzeitig wird mittels der Druckfeder 2c eine in axialer Richtung wirkende Druckkraft F erzeugt, die die beiden Hohlspindeln 3a, 3b gegeneinander presst und die je nach der Auslenkung der Feder aus der Feder-Ruhelänge im Bereich zwischen 0,5kN und 10kN liegt. Die anfänglich eingestellte Druckkraft beträgt 1kn und liegt an den Druckplatten 4a, 4b, an den Pufferscheiben 5a, 5b und damit auch an den Substratrohr-Stirnseiten 1a, 1b an. Diese Druckkraft F erzeugt zwischen den Pufferscheiben 5a, 5b einen Reibschluss, der genügt um das Eigengewicht des Substratrohres 1 und das Gewicht des Sootkörpers 9 zu halten. Die Zentrierringe 7a, 7b, 7c dienen lediglich zur Absicherung gegen ein unvorhergesehenes Abrutschen oder Durchbiegen des Substratrohres 1. Eine gewisse axiale Führung ergibt sich durch das Zusammenspiel von Hohlspindeln 3a, 3b und Zentrierträger 6, das aufgrund des vorhandenen mechanischen Spiels etwaige Radialversätze und Winkeldifferenzen zwischen den Rotationsachsen der Hohlspindeln 3a, 3b kompensiert und mechanische Spannungen vermeidet.

Das Abscheideverfahren wird beendet, sobald der Sootkörper 9 einen vorgegebenen Außendurchmesser erreicht hat, der in Abhängigkeit von der Dichte der Sootschicht zu dem vorgegebenen Außendurchmesser des hohlzylindrischen Quarzglas-Verbundkörpers führt, zuzüglich eines Aufmaßes von mindestens 1mm. Bei einer Sootdichte von etwa 30% (bezogen auf die Dichte von Quarzglas) und einem Soll-Außendurchmesser des Quarzglas-Verbundkörper von 362mm liegt der Sootkörper-Außendurchmesser beispielsweise bei etwa 520mm.

Der Sootkörper 9 hat nach dem Abscheideverfahren eine im Wesentlichen tonnenförmige Form und erstreckt sich bis kurz vor die beiderseitigen Enden des Substratrohres 1. Der aus dem Sootkörper 9 herausragende, nur geringfügig von SiO₂-Soot belegte Substratrohr-Abschnitt 1g hat eine Länge von etwa 100mm.

### Trocknungs- und Verglasungsprozess

Das Substratrohr 1 verbleibt im Sootkörper 9. Der Verbund (1; 9) aus Substratrohr 1 und Sootkörper 9 wird einer Dehydratationsbehandlung in einem Trocknungsofen in einer Inertgasatmosphäre, einer halogenhaltigen Atmosphäre oder unter Vakuum unterzogen. Das Trocknen des Sootkörpers 9 erfolgt hier thermisch durch Erhitzen auf eine Temperatur um 1100°C in einer Stickstoff-Atmosphäre. Durch Verglasen des danach erhaltenen, getrockneten SiO₂-Sootkörpers unter Vakuum wird ein synthetisches Quarzglas mit folgenden Eigenschaften erhalten:
Hydroxylgruppengehalt: etwa 200 Gew.-ppm,
Chlorgehalt: < 0,2 Gew.-ppm
Viskosität bei 1350°C: 10,77 lg(dPa·s).

Das anschließende Verglasen des Sootkörpers 9 erfolgt in einem Zonensinterofen mit vertikal orientierter Substratrohr-Längsachse 1e unter Vakuum oder in einer Atmosphäre aus Gasen, die in Quarzglas schnell diffundieren, wie beispielsweise Helium und Wasserstoff und somit keine Blasen verursachen. **Figur 4** zeigt schematisch einen Ausschnitt eines derartigen Zonensinterofens 40. Die Ofenkammer 41 umschließt einen Ofen-Innenraum 42, in dem sich ein ringförmiges Heizelement 43 sowie eine Haltevorrichtung 44 befinden. Diese umfasst eine Tragestange 45 aus faserverstärktem Kohlenstoff, die mit ihrem unteren Ende mit einem Podest 46 aus Grafit verbunden ist. Das obere Ende der Tragestange 45 wird mittels eines beweglichen Greifers (in der Figur nicht dargestellt) gehalten, und ist mittels diesem auf und ab bewegbar. Die Tragestange 45 erstreckt sich durch die Ringöffnung des Heizelements 43 und durch ein Hüllrohr 47 aus Grafit, das auf dem Podest 46 aufsteht.

Abgesehen von den Durchlässen für die Tragestange 45 sind die Hüllrohr-Stirnseiten geschlossen. Im Vergleich zu einem beidseitig offenen Hüllrohr verleihen die weitgehend geschlossenen Ober- und Unterseite 47a dem Hüllrohr 47 eine höhere Formsteifigkeit gegenüber von außen einwirkendem Druck.

Beim Verglasen verbliebt das Substratrohr 1 im Sootkörper 9. Die Haltevorrichtung 44 dient zur Halterung des Verbunds (1; 9) aus Substratrohr 1 und Sootkörper 9, dessen Gewicht über das Podest 46 von der Tragestange 45 aufgenommen wird. Wie in **Figur 5** schematisch dargestellt, umgibt das Substratrohr 1 das Hüllrohr 47. Dessen Außendurchmesser ist an den Innendurchmesser des Substratrohres 1 so angepasst, dass der beim Sintern verbleibende Ringspalt unter Berücksichtigung des höheren thermischen Ausdehnungskoeffizienten des Grafit-Hüllrohres 47 gegenüber dem Quarzglas-Substratrohr möglichst klein ist, und beispielsweise im Bereich von 1mm bis 10mm, bevorzugt weniger als 5mm beträgt.

Beim Verglasen wird das Heizelement 43 auf eine Temperatur von etwa 1400°C erhitzt und die Tragestange 45 kontinuierlich nach oben gezogen, so dass der Sootkörper 9 von oben nach unten verglast wird. Dabei schrumpft der Verbund (1; 9) auf das Hüllrohr 47 auf, so dass dessen Außendurchmesser eine untere Grenze für den Innendurchmesser des verglasten, rohrförmigen Quarzglas-Verbundkörpers definiert. Das Substratrohr 1 besteht aus natürlichem Quarzglas, das bei der Sintertemperatur eine höhere Viskosität hat als das synthetische Quarzglas des Sootkörpers 9. Bei einer Messtemperatur von 1350°C beträgt laut Tabelle 1 der Viskositätsunterschied entsprechend der Differenz der dekadischen Logarithmen der jeweiligen Viskositätswerte etwa 0,51 lg(dPa*s) [11,28 lg(dPa*s) -10,77 lg(dPa*s)].

Das Substratrohr 1 ist somit vergleichsweise thermisch stabil und verformt sich nicht oder wenig. Dadurch bewirkt es eine Stabilisierung des Sootkörpers 9 beim Verglasen. Insbesondere wird der Gefahr entgegengewirkt, dass der Sootkörper 9 beim Verglasen in sich zusammensackt und sich Umfangsfalten ausbilden oder dass es zu Aufweitungen des Innendurchmessers kommt, die zum Ausschuss führen.

Nach dem Abkühlen wird ein rohrförmiger Verbundkörper aus dem Substratrohr 1 und einer Glasschicht mit einer Dicke von etwa 41mm erhalten, die durch das Verglasen des Sootkörpers 9 erhalten worden ist. Trotz des Aufschrumpfens des synthetischen Quarzglases auf das innere Grafit-Hüllrohr 47 kann dieses nach dem Verglasen leicht entfernt werden, da Grafit einen deutlich höheren thermischen

Ausdehnungskoeffizienten als Quarzglas hat und es sich beim Abkühlen stärker zusammenzieht.

Das Quarzglas des Substratrohres 1 kann anschließend durch mechanische Bearbeitung entfernt werden; beispielsweise durch Bohren. Nach Abschleifen und Glättung der Außenwandung wird ein Quarzglas-Hohlzylinder mit einem Außendurchmesser von 360mm und einem Innendurchmesser von 290mm erhalten.

### Vergleichsbeispiel

Wie oben erläutert, trägt das Substratrohr 1 wegen seiner vergleichsweise hohen Viskosität zur Formstabilisierung des Sootkörpers 9 beim Verglasen bei.

Um die Wirkung des Substratrohres 1 auf die Formstabilisierung des Sootkörpers 9 zu untersuchen, wurde in einem ersten Vergleichsversuch das Substratrohr vor dem Verglasen entfernt und nur der Sootkörper 9 im Zonensinterofen 40 von oben beginnend nach unten verglast. Dabei sackte der Sootkörper 9 unter seinem Eigengewicht in sich zusammen und der anverglaste Bereich löste sich vom Hüllrohr 47 ab, was zu einer lokalen Aufweitung des Innendurchmessers führt. Das so erzeugte Quarzglasrohr war unbrauchbar.

Bei einem weiteren Vergleichsversuch wurde ein Substratrohr aus synthetischem Quarzglas mit den gleichen Abmessungen wie das Substratrohr 1 eingesetzt, wie es unter Nummer 3 von Tabelle 1 spezifiziert ist. Die Viskosität dieses Quarzglases ist niedriger als die Viskosität desjenigen Quarzglases, das durch Verglasen des Sootkörpers 9 erhalten wird. Es zeigt sich, dass bei Einsatz dieses Verbundkörpers das Hüllrohr eine bessere Haftung zum anverglasten Sootkörper 9 vermittelt, so es nicht zu einer großflächigen Ablösung des verglasten Materials kam. Allerdings führte das kontinuierlich zunehmende Gewicht des verglasten oberen Bereichs des Verbundkörpers zu einer Stauchung gegen Ende des Prozesses, so dass auch das so erzeugte Quarzglasrohr letztlich unbrauchbar war.

Bei einem weiteren Vergleichsversuch wurde ein Substratrohr aus synthetischem Quarzglas mit den gleichen Abmessungen wie das Substratrohr 1 eingesetzt, wie es unter Nummer 4 von Tabelle 1 spezifiziert ist. Die Viskosität dieses Quarzglases entspricht der Viskosität desjenigen Quarzglases, das durch Verglasen des Sootkörpers 9 erhalten wird. Es zeigt sich aber auch hier, dass es beim Sintern des Verbunds (1; 9) zu einer Stauchung gegen Ende des Prozesses kommt, so dass auch das so erzeugte Quarzglasrohr letztlich unbrauchbar war.

### Hängende Verglasung

Um dem Effekt des Stauchens aufgrund des Eigengewichts entgegenzuwirken, wird häufig eine Verglasungsmethode eingesetzt, bei der der Verbund (1; 9) während des Verglasens nicht permanent auf dem Podest 46 aufsteht, sondern mindestens zeitweise hängend gehalten wird. Diese Verfahrensweise, die beispielsweise aus der EP 0 701 975 B1 bekannt ist, wird hier kurz als "hängende Verglasung" bezeichnet.

Dabei wird dafür gesorgt, dass der Verbund (1; 9) entweder von Anfang an hängend im Verglasungsofen gehalten wird, oder dass die Halterung des Verbunds (1; 9) während des Verglasungsprozesses von einer stehenden zu Beginn der Verglasung in eine hängende Halterung übergehen kann, sobald sich der unvermeidliche axiale Sinterschrumpf bemerkbar macht. Zur Realisierung der hängenden Halterung können Maßnahmen am Substratrohr bereits vor Durchführung des Außenabscheideverfahrens getroffen werden. Dies kann beispielsweise durch Umformen eines Substratrohres erfolgen oder durch den Formprozess bei der Herstellung des Substratrohres, wie etwa durch Erzeugen einer Verengung der Substratrohr-Innenbohrung bei einem Ziehprozess, bei dem das Substratrohr aus einer Schmelze gezogen wird oder bei der ein Mutterrohr zu dem Substratrohr elongiert wird. Alternativ oder ergänzend dazu und gleichermaßen bevorzugt werden diese Maßnahmen "in situ" während der Verglasung generiert werden.

Eine geeignete Maßnahme zur Realisierung der hängenden Verglasung ist die Ausbildung einer Haltekante am Substratrohr, die dazu dient, dass der Verbund (1; 9) mindestens zeitweise senkrecht hängend (und nicht ausschließlich stehend) verglast wird. Durch die mindestens zeitweise hängende Halterung wird beim Verglasen zusätzlich zu dem oben erläuterten Effekt des thermisch stabilen Substratrohres 1 einem Stauchen des Sootkörpers 9 entgegen gewirkt, so dass dieser seine gewünschte Geometrie behält und Ausschuss vermieden wird.

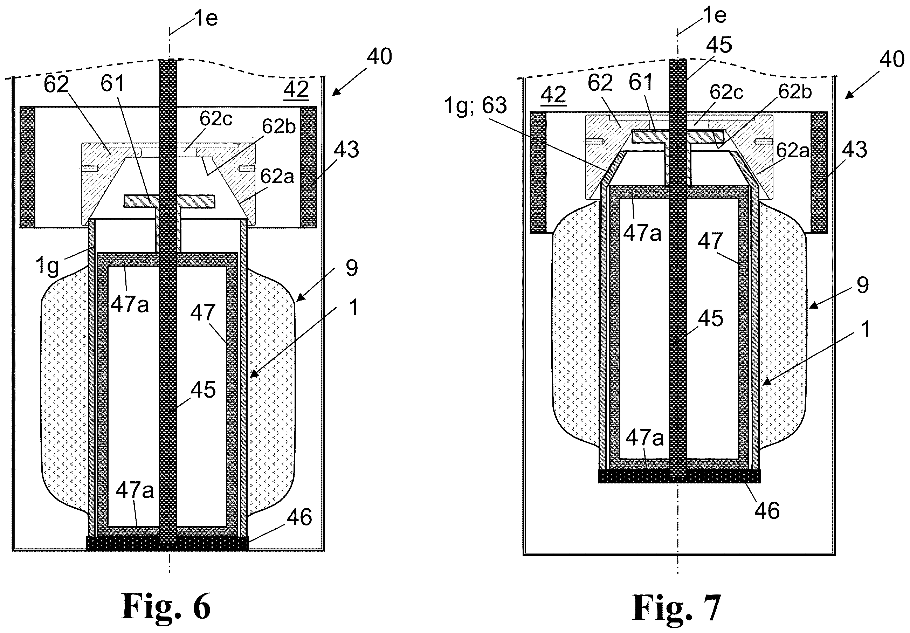

Für die Aufhängung des Verbunds (1; 9) kann beispielsweise der Substratrohr-Abschnitt 1g beim Verglasen des Sootkörpers 9 zu einer Haltekante umgeformt werden. Dafür geeignete Methoden zur Herstellung der Haltekante "in situ" werden im Folgenden anhand der Figuren 6 bis 10 näher erläutert.

**Figur 6** zeigt schematisch eine erste Methode und eine Vorrichtung zur Herstellung der Aufhängung "in situ". Der Verbund (1; 9) aus Substratrohr 1 und Sootkörper 9 wird in den Verglasungsofen 40 eingebracht und mittels Tragstange 45 und Hüllrohr 47 auf dem Podest 46 mit vertikal orientierten Sootkörper-Längsachse 1e gelagert. Auf die obere Stirnseite 47a des Hüllrohres 47 wird ein ringförmiger Abstandshalter 61 und auf die obere Stirnseite des Substratrohres 9 wird ein Konuskörper 62 in Form eines umgestülpten Bechers aufgesetzt. Der Abstandshalter 61 und der Konuskörper 62 bestehen aus Grafit. Der Konuskörper 62 hat einen Innenkonus 62a, der in eine ebene Stützfläche 62b übergeht, in der sich eine Durchgangsöffnung 62c befindet. Im Ausgangszustand liegt der Innenkonus 62 an der Außenseite des oberen Substratrohr-Abschnitts 1g an. Die Tragstange 45 erstreckt sich durch die Durchgangsöffnung 62c und durch den ringförmiges Abstandshalter 61.

Der obere Substratrohr-Abschnitt 1g wird beim Verglasungsprozess zu einer Aufhängung umgeformt. Der Umformvorgang ist schematisch in **Figur 7** gezeigt. Mittels der Tragstange 45 wird der obere Substratrohr-Abschnitt 1g so weit in das auf Verglasungstemperatur erhitzte Heizelement 43 bewegt, dass er sich erweicht. Durch sein Gewicht drückt der Konuskörper 62 den weichen oberen Substratrohr-Abschnitt 1g nach innen in Richtung der Substratrohr-Längsachse 1e. Dabei legt sich der Substratrohr-Abschnitt 1g an den Innenkonus 62a an und wird auf diese Weise zu einem Außenkonus umgeformt. Der Umformprozess ist beendet, sobald der Abstandshalter 61 an der Stützfläche 62b des Konuskörpers 62 zur Anlage kommt.

Beim weiteren Verglasen wird der Verbundkörper (1;9) mit seinem oberen Ende beginnend zonenweise erhitzt. Dabei kollabiert der Verbund (1; 9) sukzessive auf das Grafit-Hüllrohr 47 auf und schrumpft auch in seiner Länge. Die Sinterschrumpfkräfte sind dabei so stark, dass es auch zu einer Längenverkürzung beim Substratrohr 1 kommt. Allerdings ist die Längenverkürzung gering.

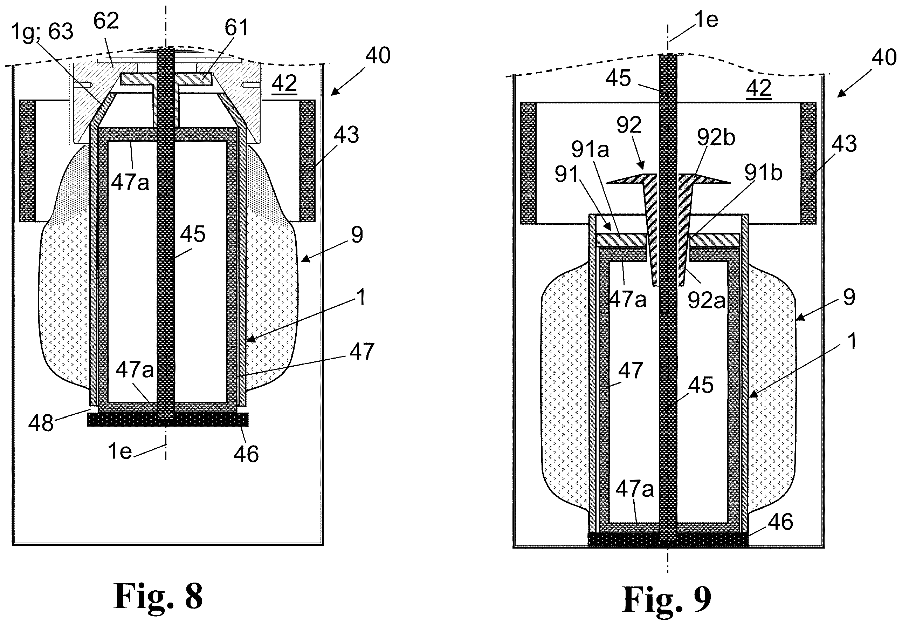

In einer ersten Verglasungsphase steht der Verbund (1; 9) auf dem Podest 46 auf. **Figur 8** zeigt schematisch eine zweite Verglasungsphase. Während dieser gelangt der zum Außenkonus umgeformte ehemalige Substratrohr-Abschnitt 1g aus dem Heizbereich des Heizelements 43, kühlt dabei ab und verfestigt sich. Er liegt mit seiner Innenseite auf der Hüllrohr-Oberseite 47a an und wirkt dann als Aufhängung 63 für den Verbund (1; 9). Dieser hebt sich infolge der Längenschrumpfung unter Bildung eines schmalen Spaltes 48 vom Podest 46 ab, was ab dann die weitere "hängende Verglasung" ermöglicht. Dies wirkt einem Zusammensacken des Sootkörpers 9 entgegen, wobei das Substratrohr 47 aufgrund seiner höheren Viskosität die Form des resultierenden, rohrförmigen Quarzglas-Verbundkörpers zusätzlich stabilisiert.

**Figur 9** zeigt schematisch eine zweite Methode und eine Vorrichtung zur Herstellung der Aufhängung in situ, also in einem Arbeitsgang mit der Verglasung des Verbunds (1; 9) aus Substratrohr 1 und Sootkörper 9. Dieser wird in den Verglasungsofen 40 eingebracht und mittels Tragstange 45 und Hüllrohr 47 auf dem Podest 46 mit vertikal orientierten Sootrohr-Längsachse 1e gelagert. Auf die obere Stirnseite 47a des Hüllrohres 47 wird ein Kreisring 91 aufgelegt, der der aus zwei oder mehr voneinander getrennten Kreissektor-Platten 91a, 91b zusammengesetzt ist, die an eine Kreisring-Mittenöffnung 91b angrenzen und die in radialer Richtung beweglich gelagert sind. In die Mittenöffnung 91b ragt von oben ein Kegelkörper 92 aus Grafit, der einen kegelförmigen Schaft 92a und einen Kegelkopf 92b mit einer ebenen Unterseite aufweist. Kreisring 91 und Kegelkörper 92 bestehen aus Grafit. Der Außendurchmesser des Kreisrings 91 entspricht etwa dem Innendurchmesser des Substratrohres 1; er liegt an der Innenwand des oberen Substratrohr-Abschnitts 1g an. Das Durchmesserprofil des Kegelschafts 92a ist so ausgelegt, dass er im Ausgangszustand etwa bis zur Hälfte in die Mittenöffnung 91b eintaucht.

Die Ausbeulung 93 gelangt beim weiteren Verglasen des Verbundkörpers (1;9) in den Bereich oberhalb des Heizelements 43, kühlt dabei ab und verfestigt sich. Der Verbundkörper (1, 9) wird mit seinem oberen Ende beginnend zonenweise erhitzt, wie dies weiter oben für die erste Methode beschrieben ist. In einer ersten Verglasungsphase steht der Verbund (1; 9) auf dem Podest 46 auf und während der zweiten Verglasungsphase dient die Ausbeulung 93 als Halterung für die "hängende Verglasung". Dabei ragen die Kreissektor-Platten 91a von innen in die Ausbeulung 93 hinein und werden darin in vertikaler Richtung zusammen mit dem Substratrohr 1 fixiert.

Länge und Innendurchmesser des danach erhaltenen Quarzglas-Verbundkörpers sind durch das Substratrohr 1 vorgegeben. Der ehemalige Sootkörper bildet eine Schicht aus transparentem synthetischem Quarzglas mit einer Schichtdicke um 41mm. Nach dem Entfernen des Quarzglasmaterials des Substratrohres 1 sowie Abschleifen und Glättung der Außenwandung wird ein Quarzglas-Hohlzylinder mit einem Außendurchmesser von 360mm und einem Innendurchmesser von 290mm erhalten. Daraus können Ätzringe für Single-Wafer Plasmaätzkammern und Druckgefäße zum Einsatz in der chemischen Verfahrenstechnik geschnitten werden.

Zur Herstellung des Ätzrings beziehungsweise des Druckgefäßes wird dabei vorzugsweise ein Verbundkörper mit einem äußeren Wandungsbereich mit einem Innendurchmesser eingesetzt, der um mindestens 1mm kleiner ist als der Soll-Innendurchmesser. Der Soll-Innendurchmesser kann durch mechanische oder chemische Bearbeitung der Verbundkörper-Innenbohrung eingestellt werden.

Nachfolgend wird ein weiteres Ausführungsbeispiel zur Realisierung einer Haltekante für die hängende Verglasung des Verbundkörpers (21, 9) anhand der Figuren 2 und 3 sowie den Figuren 11 bis 13 erläutert.

### Sootabscheideprozess

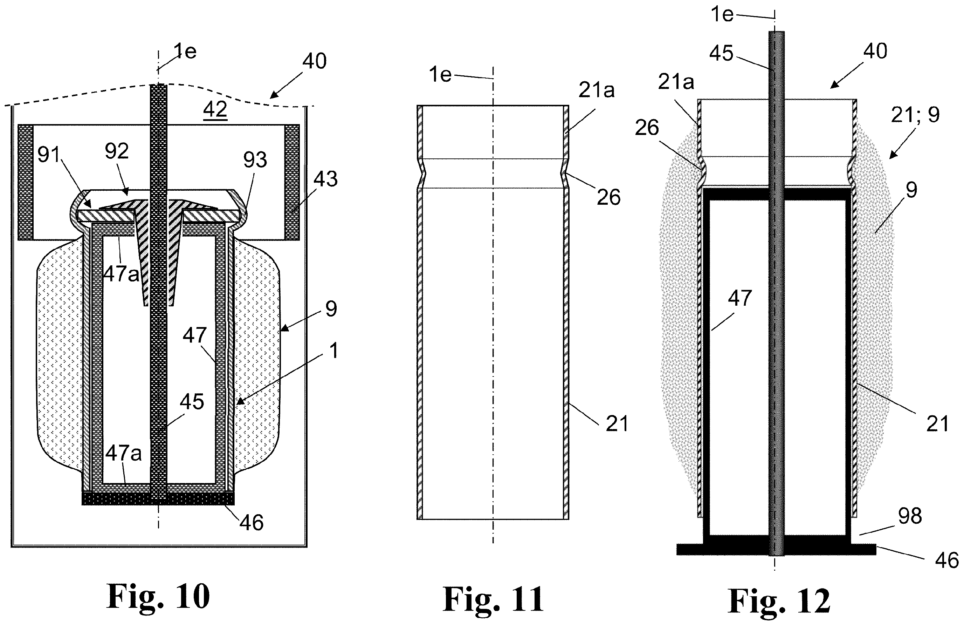

Der Sootabscheideprozess wird so geführt, wie oben anhand Figur 1 erläutert. **Figur 11** zeigt das dabei eingesetzte Substratrohr 21 in einem Längsschnitt. Im Endbereich 21a ist die vorab erzeugte Verengung 26 vorgesehen. Wie aus Figur 2 ersichtlich, wird der Sootkörper 9 so erzeugt, dass er die Verengung 26 vollständig überdeckt. Diese Maßnahme ist aber nicht zwingend erforderlich; die Verengung kann auch vollständig außerhalb des Sootkörpers 9 liegen.

Das Abscheideverfahren wird beendet, sobald der Sootkörper 9 einen vorgegebenen Außendurchmesser erreicht hat: Bei einer Sootdichte von 30% (bezogen auf die Dichte von Quarzglas) und einem Soll-Außendurchmesser des Quarzglas-Verbundkörper von 362mm liegt der Sootkörper-Außendurchmesser bei etwa 520mm.

Der nach dem Sootabscheideprozess vorliegende Verbund (21; 9) wird einer Dehydratationsbehandlung unter chlorhaltiger Atmosphäre bei einer Temperatur von 1200°C unterzogen. Durch Verglasen des danach erhaltenen, getrockneten SiO₂-Sootkörpers unter Vakuum wird ein synthetisches Quarzglas mit folgenden Eigenschaften erhalten:
Hydroxylgruppengehalt: <0,2 Gew.-ppm
Chlorgehalt: etwa 1.000 Gew.-ppm
Viskosität bei 1350°C: 10,64 Ig(dPa.s)

Der Verbund (21; 9) wird anschließend im Zonensinterofen 40 unter Vakuum verglast. **Figur 12** zeigt den im Zonensinterofen 40 eingesetzten Verbund (21; 9). Beim Verglasen wird das Heizelement 43 auf Verglasungstemperatur von etwa 1400°C erhitzt und die Tragestange 45 nach kontinuierlich nach oben gezogen, so dass der Sootkörper 9 von oben nach unten verglast wird. Dabei schrumpft der Verbund (21; 9) auf das Grafit-Hüllrohr 47 auf, so dass dessen Außendurchmesser eine untere Grenze für den Innendurchmesser des verglasten Quarzglas-Verbundkörpers definiert. Da das Substratrohr 21 aus einem Quarzglas besteht, das bei der Verglasungstemperatur eine höhere Viskosität hat als das Quarzglas des Sootkörpers 9, verformt es sich nicht oder wenig und bewirkt eine Stabilisierung des Sootkörpers 9 beim Verglasen. Insbesondere wird der Gefahr entgegengewirkt, dass der Sootkörper 9 beim Verglasen gestaucht wird und sich Umfangsfalten ausbilden oder es zu und Aufweitungen des Innendurchmessers kommt.

Im dargestellten Verfahrensstadium ist der Verglasungsprozess bereits fortgeschritten und eine gewisse Schrumpfung des Sootkörpers 9 hat bereits stattgefunden. Dadurch ist der Übergang von der anfänglichen Verglasungsphase mit stehendem Verbund (21; 9) zu der "hängenden Verglasung" bereits abgeschlossen. Durch das Schrumpfen des Sootkörpers 9 hat sich auch die Länge des Substratrohres 21 ein wenig verkürzt, und es hat sich unter Bildung des Spalts 98 bereits ein Stück vom Podest 46 abgehoben.

Bei einer alternativen Verfahrensweise wird der Verbund (21; 9) von Anfang an im Zonensinterofen hängend gehalten, indem die bereits vor dem Sootabscheideprozess vorhandene Verengung 26 auf der Oberkante des Grafit-Hüllrohres 47 aufliegt.

Nach dem Abkühlen wird ein Verbundkörper 100 (Figur 13) aus dem Substratrohr 21 und einer Glasschicht 9a mit einer Dicke von etwa 41mm erhalten, die durch das Verglasen des Sootkörpers 9 erhalten worden ist.

Bei einem Vergleichsversuch wurde ein Substratrohr aus synthetischem Quarzglas mit den gleichen Abmessungen wie das Substratrohr 21 eingesetzt, wie es unter Nummer 3 von Tabelle 1 spezifiziert ist. Die Viskosität dieses Quarzglases ist höher als die Viskosität desjenigen Quarzglases, das durch Verglasen des Sootkörpers 9 erhalten wird. Genauer gesagt, ist der dekadische Logarithmus der Viskosität dieses Quarzglases bei einer Messtemperatur von 1350°C um 0,13 lg(dPa*s) höher als der dekadische Logarithmus der Viskosität desjenigen Quarzglases, das durch Verglasen des Sootkörpers 9 erhalten wird.

Es zeigt sich aber, dass dieser Viskositätsunterscheid zu gering ist, um beim Sintern des Verbundkörpers dem großvolumigen und schweren Substratrohr eine ausreichende Stabilität zu verleihen.

**Figur 13** zeigt einen Querschnitt des nach dem Verglasen erhaltenen Verbundkörpers 100 in einer Ansicht entlang der in Figur 2 eingezeichneten Linie A'-A". Zu erkennen ist das Substratrohr 1 mit der Durchgangsbohrungen 1f, die Durchmesser-Verengung 26 und die nach dem Verglasen erhaltene Schicht 9a aus synthetischem Quarzglas.

Nach dem Entfernen des Quarzglasmaterials des Substratrohres 21 sowie Abschleifen und Glättung der Außenwandung wird ein Quarzglas-Hohlzylinder mit einem Außendurchmesser von 360mm und einem Innendurchmesser von 290mm erhalten. Daraus können Ätzringe mit den entsprechenden Innen- und Außendurchmesserwerten - oder mit größeren Innen- und kleineren Außendurchmesserwerten - für den Einsatz zum Halten von Halbleiterwafern in Single-Wafer Plasmaätzkammern oder Druckbehälter für den industriellen Einsatz gesägt werden.

## Patentansprüche

1. Verfahren zur Herstellung eines rohrförmigen Quarzglas-Verbundkörpers in einem Außenabscheideverfahren umfassend die folgenden Verfahrensschritte:
(a) Bereitstellen eines Substratrohres, das eine durchgehende und koaxial zu einer Substratrohr-Längsachse verlaufende Durchgangsöffnung, einen Substratrohr-Außendurchmesser, einen Substratrohr-Innendurchmesser, eine Substratrohr-Wandstärke, eine Substratrohr-Außenmantelfläche und eine Substratrohr-Innenmantelfläche aufweist,
(b) Rotieren des Substratrohres um eine koaxial oder parallel zur Substratrohr-Längsachse verlaufende Rotationsachse,
(c) Abscheiden von SiO₂-Partikeln auf der Außenmantelfläche des Substratrohres mittels mindestens eines Abscheidebrenners unter Bildung eines Verbunds (1/9; 21/9) aus dem Substratrohr und einem SiO₂-Sootkörper,
(d) Sintern des Verbunds (1/9; 21/9) durch Erhitzen bei einer Sintertemperatur unter Bildung des rohrförmigen Quarzglas-Verbundkörpers (100),
**dadurch gekennzeichnet, dass** ein Substratrohr bereitgestellt wird, das mindestens teilweise aus Quarzglas einer ersten Quarzglasqualität besteht, und dass der Sootkörper aus Quarzglas einer zweiten Quarzglasqualität besteht, wobei die erste Quarzglasqualität bei der Sintertemperatur eine materialspezifische Viskosität aufweist, die höher ist als die materialspezifische Viskosität der zweiten Quarzglasqualität.

2. Verfahren nach Anspruch 1, **dadurch gekennzeichnet, dass** bei einer Messtemperatur von 1350°C der dekadische Logarithmus der Viskosität der ersten Quarzglasqualität um mindestens 0,25 lg(dPa*s), vorzugsweise um mindestens 0,4 lg(dPa*s) besonders bevorzugt um mindestens 0,6 lg(dPa*s) höher ist als der des Quarzglases der zweiten Quarzglasqualität.

3. Verfahren nach Anspruch 1 oder 2, **dadurch gekennzeichnet, dass** das Quarzglas der ersten Quarzglasqualität einen Gehalt an Aluminiumoxid aufweist, der um mindestens 5 Gew.-ppm, bevorzugt um mindestens 10 Gew.-ppm höher ist als der Gehalt an Aluminiumoxid im Quarzglas der zweiten Quarzglasqualität.

4. Verfahren nach einem oder mehreren der vorhergehenden Ansprüche, **dadurch gekennzeichnet, dass** das Quarzglas der ersten Quarzglasqualität einen Hydroxylgruppengehalt von weniger als 30 Gew.-ppm, vorzugsweise einen Hydroxylgruppengehalt von weniger als 20 Gew.-ppm aufweist.

5. Verfahren nach einem oder mehreren der vorhergehenden Ansprüche, **dadurch gekennzeichnet, dass** das Quarzglas der ersten Quarzglasqualität aus einem natürlich vorkommenden Rohstoff erschmolzen ist.

6. Verfahren nach einem oder mehreren der vorhergehenden Ansprüche, **dadurch gekennzeichnet, dass** das Substratrohr eine Wanddicke im Bereich von 1,5mm bis 10mm aufweist, vorzugsweise im Bereich von 4 bis 8mm.

7. Verfahren nach einem oder mehreren der vorhergehenden Ansprüche, **dadurch gekennzeichnet, dass** der Sootkörper im Wesentlichen zylinderförmig ausgebildet ist und eine Wanddicke hat, die nach dem Sintern des Verbundkörpers eine Glasschicht ergibt, die eine Schichtdicke im Bereich von 25mm bis 100mm aufweist, vorzugsweise im Bereich von 30mm bis 60mm.

8. Rohrförmiger Verbundkörper aus Quarzglas, mit einer Länge von mindestens 1000mm, einer Rohrwandung und mit einem Innendurchmesser von mindestens 250mm, **dadurch gekennzeichnet, dass** die Rohwandung einen inneren Wandungsbereich und einen äußeren Wandungsbereich umfasst, wobei der innere Wandungsbereich mindestens teilweise aus Quarzglas einer ersten Quarzglasqualität besteht, und der äußere Wandungsbereich aus Quarzglas einer zweiten Quarzglasqualität besteht, wobei bei einer Messtemperatur von 1350°C die Viskosität der ersten Quarzglasqualität höher ist als die Viskosität der zweiten Quarzglasqualität.

9. Verbundkörper nach Anspruch 8, **dadurch gekennzeichnet, dass** bei einer Messtemperatur von 1350°C der dekadische Logarithmus der Viskosität der ersten Quarzglasqualität um mindestens 0,25 lg(dPa*s), vorzugsweise um mindestens 0,4 lg(dPa*s) besonders bevorzugt um mindestens 0,6 lg(dPa*s) höher ist als der des Quarzglases der zweiten Quarzglasqualität.

10. Verbundkörper nach Anspruch 8 oder 9, **dadurch gekennzeichnet, dass** das Quarzglas der ersten Quarzglasqualität einen Gehalt an Aluminiumoxid aufweist, der um mindestens 5 Gew.-ppm, bevorzugt um mindestens 10 Gew.-ppm höher ist als der Gehalt an Aluminiumoxid im Quarzglas der zweiten Quarzglasqualität.

11. Verbundkörper nach einem oder mehreren der Ansprüche 8 bis 10, **dadurch gekennzeichnet, dass** das Quarzglas der ersten Quarzglasqualität aus einem natürlich vorkommenden Rohstoff erschmolzen ist.

12. Verbundkörper nach einem oder mehreren der Ansprüche 8 bis 11, **dadurch gekennzeichnet**, und dass der innere Wandungsbereich aus dem Quarzglas der ersten Qualität eine Wanddicke im Bereich von 1,5mm bis 10mm, vorzugsweise im Bereich von 4 bis 8mm aufweist.

13. Verbundkörper nach einem oder mehreren der Ansprüche 8 bis 12, **dadurch gekennzeichnet**, und dass der äußere Wandungsbereich eine Wanddicke im Bereich von 25mm bis 100mm, vorzugsweise im Bereich von 30mm bis 60mm aufweist.

14. Verwendung des rohrförmigen Verbundkörpers nach einem oder mehreren der Ansprüche 9 bis 13 zur Herstellung von Ätzringen für die Halbleiterfertigung oder eines Druckgefäßes, wobei durch Entfernen des inneren Wandungsbereichs ein Quarzglas-Hohlzylinder erzeugt und dieser zu den Ätzringen beziehungsweise dem Druckgefäß verarbeitet wird.

15. Verwendung nach Anspruch 14, **dadurch gekennzeichnet, dass** der Ätzring beziehungsweise das Druckgefäß einen vorgegebenen Soll-Innendurchmesser aufweisen, und dass zur Herstellung des Ätzrings beziehungsweise des Druckgefäßes ein Verbundkörper mit einem äußeren Wandungsbereich mit einem Innendurchmesser eingesetzt wird, der um mindestens 1mm kleiner ist als der Soll-Innendurchmesser.
